(19) Europäisches Patentamt / European Patent Office / Office européen des brevets

(11) **EP 2 863 526 A1**

(12) **EUROPEAN PATENT APPLICATION**

(43) Date of publication:
22.04.2015 Bulletin 2015/17

(51) Int Cl.:
*H02M 1/088* (2006.01)  *H02M 3/158* (2006.01)
*H02M 1/00* (2007.01)

(21) Application number: 13306449.3

(22) Date of filing: 21.10.2013

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: ST-Ericsson SA
1228 Plan-les-Ouates (CH)

(72) Inventor: **Michal, Vratislav**
**38100 Grenoble (FR)**

(74) Representative: **Casalonga**
**Casalonga & Partners**
**Bayerstraße 71/73**
**80335 München (DE)**

(54) **Switched mode power supply peak-efficiency detection**

(57) The invention relates to a Peak Efficiency Detection system comprising a Switched Power Supply, module (200) adapted to provide an output supply signal of the device. Said SPS module (200) comprising an internal central node (N_2), a plurality of SPS circuits (210) adapted to generate in combination the output supply signal on the internal central node (N_2), and a Dead type module (800) adapted to generate two control signals (CMD_P) and (CMD_N). A central node (N_1) external to the SPS module and adapted to deliver the output supply signal to a load module (500). A Peak-efficiency Detection FED module (300) adapted to receive the output supply signal from the central node, the control signals from the SPS module (200), signals (EN_P, EN_N) from a Power stage size control module (400) and to provide a signal (PEAK_D) representative of an efficiency of the SPS module (200), the Power stage size control module (400) adapted to provide at least two control signals for controlling the SPS module (200).

FIG. 1

EP 2 863 526 A1

**Description**

**Technical Field**

The present invention generally relates to Switched Mode Power Supplies (SMPS), and more particularly to techniques of detecting a peak efficiency of a switched power stage.

**Related Art**

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

Switched Mode Power Supplies (SMPS) DC/DC converter are used in an increasing number of electronic applications, such as cellular phones, laptop computers, etc., due to their better efficiency than linear power supplies. Indeed, SMPS have lower power losses than linear power supplies. Another advantage of SMPS is their capability to provide a stabilized supply current or supply voltage to a load.

Controlling the stability of the power supply signal is a very important challenge for SMPS manufacturers. Indeed, new electronic devices such as tablets or cellular phones, for instance, need a well stabilized continuous voltage supply despite variations of temperature and variations of power consumption during their use for a phone call or during a video recording, for instance. To meet these needs, it is necessary to control in continuous the voltage supplied to the electronic device and to adjust the operation of the SMPS.

A solution allowing to control the supply voltage delivered to the load by an output stage of the SMPS can consist in monitoring in continuous the output voltage by an controller generation to the duty-cycle signal delivered to the power-stage made of power switches such as power MOS (Metal Oxyde Semiconductor) transistors.

A main disadvantage of this solution, however, is that the output supply voltage cannot be efficiently controlled to accurately account for the intrinsic losses of the MOS transistors. Theses losses comprise static and dynamic contributions, namely conduction losses and switching losses, respectively. Indeed, with a view to increase the life-time of the battery, for instance, it is necessary to determine all losses of the SMPS in with respect to the power needs of the load. As a result, the size of the output stage can be dynamically optimized in order to avoid extra power-losses inside the SMPS during the discharge of the battery, due to the switching losses occurring during normal operation of the device.

**SUMMARY**

The present invention provides an alternative solution for controlling efficiency of the switched power supply module with aim to target best possible power-efficiency for given operating point. The system is both reliable and efficient, and in addition cheap to manufacture.

According to a first aspect of the invention, there is proposed a Peak Efficiency Detection (PED) system comprising:

- a Switched Power Supply (power-stage) SPS, module adapted to provide an output supply signal of the device, comprising at least:

    ▪ an internal central node; and,

    ▪ a plurality of SPS circuits adapted to generate in combination the output supply signal on the internal central node,

    ▪ a Dead-time module adapted to generate two control signals with small non-overlap time,

- a central node external to the SPS module and adapted to deliver the output supply signal to a load module,
- a PED module adapted to receive the output supply signal from the central node, the control signals from the SPS module (*CMD_P, CMD_N*), signals from a Power stage size control module and to provide a signal PEAK_D representative of an efficiency of the SPS module, comprising at least:

    ▪ a Signal Formatting module adapted to provide a formatted signal from the output supply signal,

    ▪ a Replica Losses module adapted to provide a signal representative of ohmic and switching losses of the SPS module based on the formatted signal,

- the Power stage size control module adapted to provide at least two digital control signals (*EN_N, EN_P*) for controlling the SPS module,

**wherein,** the SPS module is configured to activate or deactivate at least one of the SPS circuits operating to generate the output supply signal on the internal central node, when the signal generated by the PED module and representative of the efficiency of the SPS module is lower than a threshold value meaning that the dynamic losses of the SPS module are preponderant over the ohmic losses, or when said signal representative of the efficiency of the SPS module is higher than the threshold value meaning that the ohmic losses of the SPS module are preponderant over the dynamic losses, respectively.

In an exemplary embodiment of the invention, the SPS circuits comprise at least one power switch, and this Power Switch is made by a power Metal Oxyde Semiconductor, MOS, transistor.

In an exemplary of embodiment of the invention, data transfers are performed by a communication in order to allow communication between the PED module, the power stage size control module, and the SPS module.

Moreover, in other exemplary embodiment of the invention, in order to obtain accurate replica Ohmic losses, the ohmic losses module comprises at least a sense-FET transistor configured to create a image of the current delivered to the output by the SPS circuits. This replica is done with a scale ratio in order to deliver a current helping to create a image of the ohmic losses of the SPS circuits.

Further, in order to obtain accurate replica Switching losses, the Switching losses module comprises at least an auxiliary capacitor made by a MOS transistor (MOS capacitor) configured to be charged by the current representative of the ohmic losses of the SPS circuits and to derive the from of a voltage representative of the power-losses of the activated SPS circuits.

In a second aspect of the invention, it is proposed a method of a Peak Efficiency Detection system, PED, for a Switched Mode Power Supply, SMPS, comprising:

- a Switched Power Supply, SPS, module providing an output supply signal of the device with

    ▪ at least some of a plurality of SPS Circuit generating in combination said output supply signal on an internal central node to the SPS module,

    ▪ a Dead time module providing two control signals (*CMD_P* and *CMD_N*),

- a central node external to the SPS module delivering the output signal to the load module,

- a PED module receiving the output supply signal from the central node, the control signals (*CMD_P, CMD_N*) from the SPS module, the signals (*EN_N, EN_P*) from a power stage size control module, and providing a signal *PEAK_D* representative of an efficiency of the SPS module, with:

    ▪ a Signal Formatting module providing a formatted signal from the output supply signal,

    ▪ a Replica Losses module providing a signal representative of ohmic and switching losses of the SPS module based on the formatted signal,

- a Power stage size control module providing at least two control signals (*EN_P, EN_N*) for controlling the SPS module, wherein the method further comprises:

    - activating or deactivating at least one of the SPS circuits operating to generate the output supply signal on the internal central node, when the signal generated by the PED module and representative of the efficiency of the SPS module is lower than a threshold value meaning that the dynamic losses of the SPS module are preponderant over the ohmic losses, or when said signal representative of the efficiency of the SPS module is higher than the threshold value meaning that the ohmic losses of the SPS module are preponderant over the dynamic losses, respectively.

In other exemplary embodiment of the invention the duration of conduction of the Switched Power Circuits is controlled by the control signals duty-cycle.

In other exemplary embodiment of the invention each transistor of each SPS circuit is activated by a control signals.

## BRIEF DESCRIPTION OF THE DRAWINGS

Embodiments of the present invention are illustrated by way of example, and not by way of limitation, in the figures of the accompanying drawings, in which like reference numerals refer to similar elements and in which:

- FIG.1 is a simplified block diagram of a Switched-Mode Power Supply device containing the peak-efficiency module PED, according to an embodiment of the proposed solution,

- FIG.2 is a simplified block diagram of an embodiment of the SPS module (power-stage) with variable size of the device of FIG.1,

- FIG.3 is a simplified block diagram of one of a plurality of a SPS segments comprised in the SPS module of FIG.2,

- FIG.4 is a simplified block diagram of another embodiment of the SPS circuits,

- FIG.5 shows a sequence, as a function of time, of signals and voltages of the device according to embodiments,

- FIG.6 is more detailed circuit diagram showing the internal structure of a SPS circuit including the main losses elements,

- FIG.7 is a more simplified circuit diagram showing the internal structure of a SPS circuit including main losses elements,

- FIG.8 is a simplified block diagram of a PED module according to another embodiment,

- FIG.9 shows a sequence, as a function of time, of signals and voltages the device according to embodiments,

- FIG.10 is an example of internal electronic circuitry of a first main module of the PED module,

- FIG.11 is an example of internal electronic circuitry of a second main module of the Peak Efficiency module embodying another proposed solution,

- FIG.12 is a graph representing the simulation of the Peak Detention embodying the proposed solution,

- FIG.13 is a block diagram of the internal electronic circuitry of the Power stage size control module (Peak-Efficiency Tracking) according to another embodiment bodying another the proposed solution,

- FIG.14 are graphs comparing the power efficiency of a Switched Power Supply module not embodying, or embodying, respectively, the proposed power regulation strategy.

## DESCRIPTION OF PREFERRED EMBODIMENTS

Embodiments as described herein are directed to a device and a method for adjusting automatically the number of Switched Power Supply (SPS) circuits, also referred to as power stages segments, to obtain optimal peak efficiency of a SPS module.

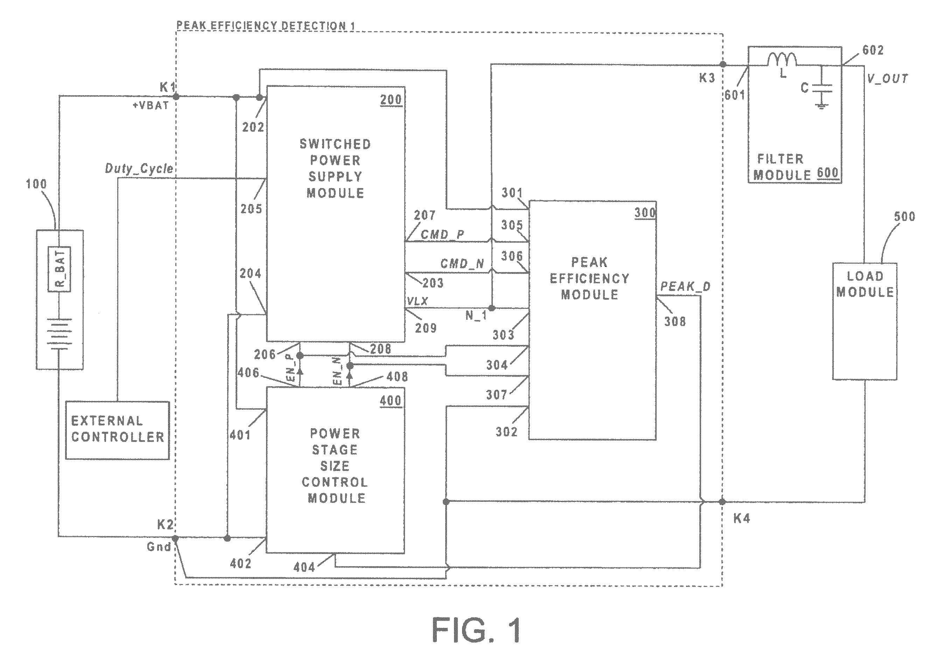

Referring to **FIG.1,** there is shown therein a simplified bloc diagram of a Peak Efficiency Detection (PED) device 1 containing also the power-stage module, to which embodiments of the invention can be applied.

The proposed PED device 1 may be run upon a start-up of electronic devices such as a tablet for instance, supplied by a Switched Mode Power Supply (SMPS) embodying said device 1. Indeed, the SMPS device has applications for controlling a current or a voltage supply delivered to a load when, for instance, the temperature of electronic components vary during the device run or when the activity of the electronic device increases, for instance, during a power consuming phase of operation such as video recording.

In one embodiment of the invention, the PED device 1 comprises three main blocks such as a first main block named SPS module, a power-stage 200 and adapted to provide a output voltage $VLX$ to a Filter-module 600, a second main block named PED module 300 and adapted to provide a signal named $PEAK\_D$ representing the efficiency of the SPS module 200, and a third main block named Power stage size control module 400 and adapted to provide a first control signal named $EN\_P$ and a second control signal named $EN\_N$ for controlling the amount of activated SPS module 200 and the PED module 300 in function of a determined strategy which will be described in more details below.

Further, the PED device 1 comprises two input terminals K1 and K2 coupled to a power supply voltage source 100, and two output terminals K3 and K4 to which a Filter module 600 is coupled.

Furthermore, the PED device 1 comprises an internal central node N_1 adapted to dispense the power supply signal *VLX* from the SPD module 200 to the PED module 300 and to the Load module 500 through the Filter module 600.

The source 100 may be a battery or another type of power supply voltage generator able to provide one DC voltage such as voltage *+VBAT* referenced to Gnd. The source 100 is coupled to the input terminals K1 and K2, respectively, of the device 1. In the shown example, the power supply voltage generator 100 comprises an internal parasitic resistor R_BAT representative of the total internal resistance of the generator 100. The Load module 500 could be an electronic circuit of a cellular phone or a laptop computer, for instance. These examples are not restrictive of the many applications of the proposed device.

The Filter module 600, placed between the output terminal K3 and the Load module 500 comprises an inductor (L) coupled with a capacitor (C) allows to obtain a particular cut-off frequency determinate by the inductor and capacitor values. The Filter module 600 is adapted to receive the output signal *VLX* from the central node N_1 through the output terminal K3, and is adapted to provide a smoothed signal named *V_OUT* to an input of the Load module 500. The Filter module 600 can use several additional components (capacitors, resistors, and inductances), and these components could be integrated during the conception on a silicon chip of the PED device 1.

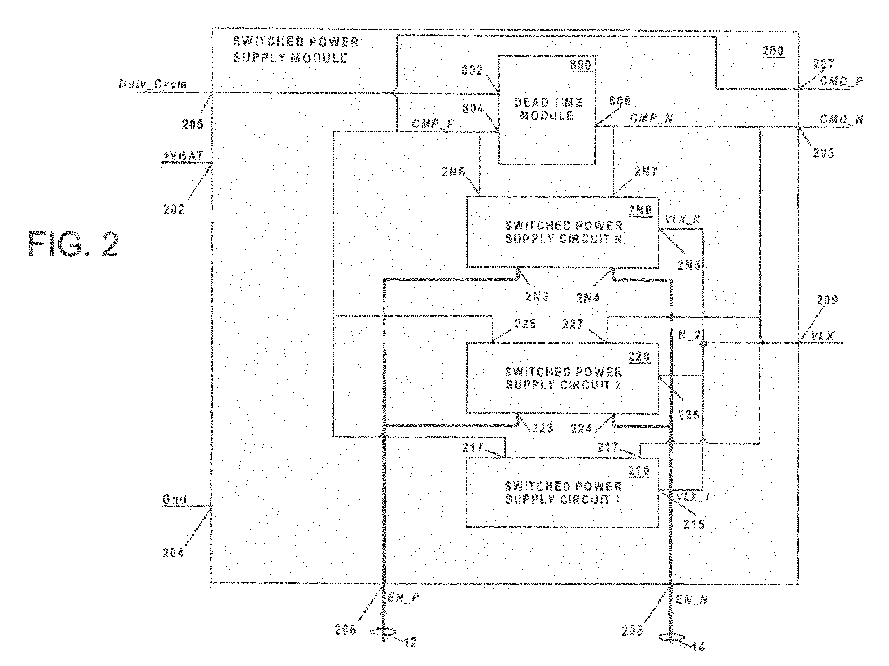

The SPS module 200 as shown on **FIG.2** comprises a plurality of SPS circuits 210, 220,..., 2N0, a Dead time module 800, two power supply inputs 202 and 204 for supplying all SPS circuits, two another inputs 206 and 208 adapted to receive two control signals *EN_N* and *EN_P* from the Power stage size control module 400, an input 205 adapted to receive a signal named *Duty_Cycle* allows to control the duration of conduction of the switched power supply circuits., an output 209 adapted to provide the supply signal named *VLX* to the central node N_1 of the PED device 1, and two outputs 207 and 203 adapted to provide two signals named respectively *CMD_P* and *CMD_N.* Further, the SPS module 200 comprises an internal central node N_2 which is identical as N_1 node.

The Dead time module 800 is adapted to receive on an input 802 the *Duty_cycle* signal form an external controller, and is adapted to provide on a first output 804 a signal named *CMD_P* and on a second output 806 a signal named *CMD_N.* These signals are slightly non-overlapping. The frequency and duration of a high state of the *Duty_cycle* signal are adjustable by an external controller.

The SPS circuit 210, is adapted to receive on inputs 216 and 217 two input signals from the Dead time module 800 with the first input signal named *CMD_P* enables to control the duration of conduction of a transistor PMOS of the switched power supply circuit 210 and the second input signal named *CMD_N* that enables to control the duration of conduction of a transistor NMOS of the said circuit.. The switched power supply circuit 210 comprises an output 215 adapted to provide a supply signal named *VLX_1* to the internal central node N_2 of the switched power supply module 200.

The Switched Power Supply Circuit 220, for instance, comprises two inputs 226 and 227 adapted to receive two input signals *CMD_P* and *CMD_N* from the Dead time module 800 that enable to control the duration of conduction of PMOS and NMOS transistors of the said circuit. Furthermore, the switched power supply circuit 220 comprises two another inputs 223 and 224 adapted to receive respectively the signals *EN_P 220* and *EN_N 22*0 from the from the Power stage size control module 400 through the inputs 206 and 208 of the SPS module 200. These signals (*EN_P220* and *EN_N22*0) allow activating or disabling each transistor of each SPS circuit in function of a defined power regulation strategy that will be described in more details below. The SPS circuit 220 comprises an output 225 adapted to provide a signal *VLX_2* of the SPS module 200 as its contribution to the generated output supply voltage *VLX*. The signal VLX is representative in the following description to the power delivered by all activated SPS circuit (210, 220,..., 2N0) of the SPS module 200.

For the sake of simplicity of the present description, only the SPS circuit 220 has been described but it will be appreciated that, referring to the **FIG.2** all SPS circuits (without the switched power supply circuit 210) may have same internal characteristics and same internal design (circuits, components). Furthermore, the number of SPS circuits and their characteristics are defined during the design of the SPS module 200 depending on the specific application. To that end, they may be integrated in a same chip for reaching a minimum mismatch of characteristics. Further, all outputs of all SPS circuits are coupled to the internal central node N_2 of the Switched Power Supply module 200.

Referring to **FIG.1,** the Power stage size control module 400 comprises one input 404 adapted to receive the signal *PEAK_D* from an output of the PED module 300, and comprises two outputs 406 and 408 adapted to provide two signals *EN_P* and *EN_N,* respectively. The first signal *EN_P* and the second signal *EN_N* enable to activate or disable each PMOS transistor and NMOS transistor of each switched power supply circuit in function of the signal *PEAK_D* and a define strategy that will be described in more details bellow.

As presented above, one of the goals of the PED module 300 is to detect the peak efficiency of the SPS module 200. To that end, all losses in the SPS circuit 200 are determined during the operation of the SPS module 200 in order, for instance, to avoid the useless power losses. The efficiency of the device is mainly determined by the configuration of the SPS module 200, particularly size of the associated power MOS transistors. Mainly two set points can control the efficiency of the SPS module 200.

The first point of control is the size of the structure, which may be optimised during the conception of power MOS transistors used in the SPS module 200 and their associated circuitry. Further, the number of activated SPS circuits may be dynamically adapted as a function of the power needs of the load 500.

The second point which allows obtaining high efficiency of the SPS module 200 is the Power stage size Control module 400. Indeed, this module enables to activate or disable each power MOS transistor of the SPS circuits depending on the power requirement of the load 500 and other parameter of the circuit. The said Power stage size control module 400 is adapted to provide several control signals to the SPS module 200 in order to control the number of activated Switched Power Stage Circuits, and the duration of the conduction of said SPS Circuits. The Power stage size control module 400 presented above is adapted to monitor several parameters such as number of activated subscircuits and duration of conduction of PMOS and NMOS transistors of the SPS module 200 for controlling the output supply signal *VLX*.

The power supply signal *VLX* (as shown on **FIG.2)** provided by the SPS module 200 results from the addition of the contributions provided by the activated SPS circuits summed at the internal central node N_2 according to the Kirchoff laws. The activation of each PMOS and NMOS transistors of the SPS circuits in accordance with a power regulation strategy is performed by signals *EN_N and EN_P*. A direct connection by the communication bus 12 may be used to provide the EN_N and EN_P signals. In these examples, the *EN_N* and *EN_P* signals can comprise an address signal and a command signal allowing to activate or disable each of the SPS subcircuits in function of the defined strategy.

Two another parameters may allow controlling the power supply signal *VLX* such as the frequency and the duty cycle of the signals *CMD_P* and *CMD_N.* For explaining the influence of these parameters on the power supply signal *VLX* the internal structure of a Switched Power Supply Circuit will be first described.

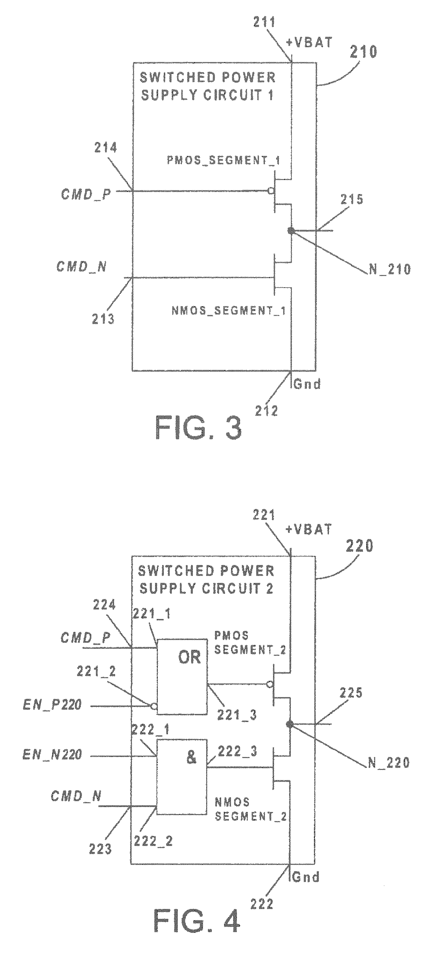

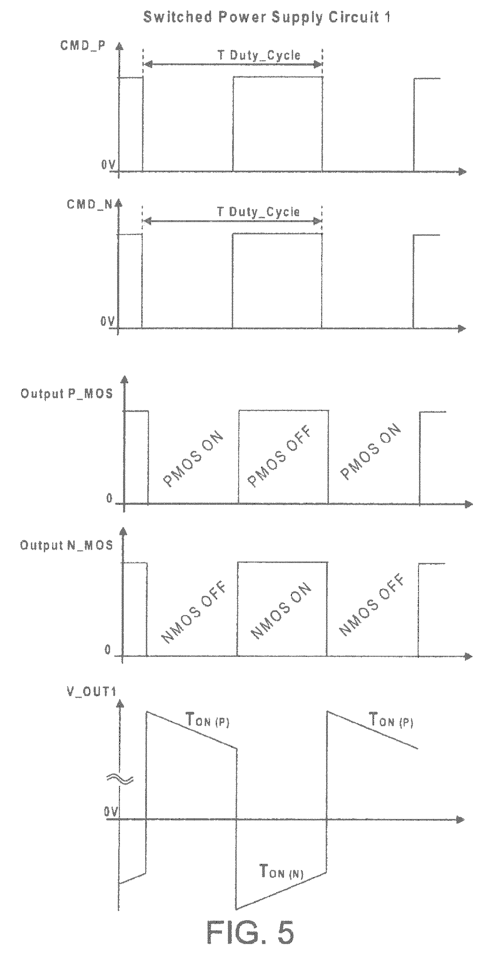

**FIG.3** and **FIG.4** show two examples of internal structure of a SPS circuit and **FIG.5** shows various associated signals. It will be appreciated that only the SPS circuit 220 will be described in details, said description being valid for the other SPS subcircuits as well. Furthermore, it will be appreciated that, on **FIG.5,** the duty cycle of signals *CMD_P and CMD_N* is equal to 0.5.

The SPS circuit 210 shown in **FIG.3** comprises two power MOS transistors with a first PMOS transistor PMOS_SEGMENT_1, a second NMOS transistor NMOS_SEGMENT_1. A gate of the transistor PMOS_SEGMENT_1 is coupled to the input 214 of the switched power supply circuit 210 and is adapted to be controlled by the signal *CMD_P.* A gate of the transistor NMOS_SEGMENT_1 is coupled to the input 213 of the said circuit and is adapted to be controlled by the signal *CMD_N.* Further, a source of the transistor PMOS_SEGMENT_1 is coupled to a VBAT, and source of the transistor NMOS_SEGMENT_1 to GND. A node named N_210 on the FIG.3 placed between the drains of the two transistors is adapted to dispense the signal *VLX_1* through the output 215 of the switched power supply circuit 1. As the transistors in this segment are hard connected to the *CMD_P* and *CMD_N* signals, this first segment is always active (means that it cannot be deactivated)

The switched power supply circuit 220 shown on **FIG.4** comprises two MOS transistors with a first transistor PMOS_SEGMENT_2, and a second transistor NMOS_SEGMENT_2, and comprises two logical structures named logical_221 and logical 222. The logical structure _221 is adapted to receive on a first input 221_1 the signal CMD_P from the Dead time module 800 and on a second input named 221_2 the signal EN_P2 from the Power stage size control module 400. The logical structure 221 is adapted to provide on an output 221_3 a signal representative of an OR-type boolean calculation between the said two input signals. The output 221_3 of the structure logical 221 is coupled to a gate of the PMOS_SEGMENT_2 transistor.

The structure logical_222 is adapted to receive on a first input 222_1 the signal CMD_N from the dead time module 800 and on a second input named 222_2 the signal EN_N2 from the Power stage size control module 400. The logical structure _222 is adapted to provide on an output 222_3 a signal representative of an AND-type boolean calculation between the said two input signals. The output 222_3 of the structure logical 222 is coupled to a gate of the NMOS_SEGMENT_2 transistor.

Further, a node named N_220 on the FIG.5 placed between the drains of the two transistors is adapted to provide the signal VLX_2 through the output 225 of the switched power supply circuit 2.

In one embodiment, the signals *CMD_P* and *CMD_N* of the inputs 12 and 14 have the same shape (as shown in **FIG.5).** In other embodiment, a delay may be created between the two signals *CMD_P* and *CMD_N,* this delay allowing to avoid any risk of crossconduction due to the simultaneous conduction of the two transistors.

The graphs on **FIG.5** show different signals and illustrate different states of the transistors during one period of operation. The output signal *VLX_1* **(FIG.5)** is the sum of the output signals of the transistor PMOS SEGMENT_1 and NMOS_SEGMENT_1 when they are in the "ON" states. The range values of said output signal *VLX_1* depends on the voltage value *+VBAT.*

In other embodiment, the frequency and the duty cycle of the signals *CMD_P* and *CMD_N* allow controlling the duration of conduction of each transistor such that if the low state duration of the signal *CMD_P* and *CMD_N* is higher then the duration of conduction of the transistor PMOS SEGMENT_1 will be longer and the duration of conduction of the transistor NMOS SEGMENT_1 will be shorter, and vice versa This principle of operation of the transistors is known by one with ordinary skills in the art as the commutation mode. Thereby, the output power supply signal *VLX_1* can be controlled by the duty cycle and the frequency of the signals *CMD_P* and *CMD_N.*

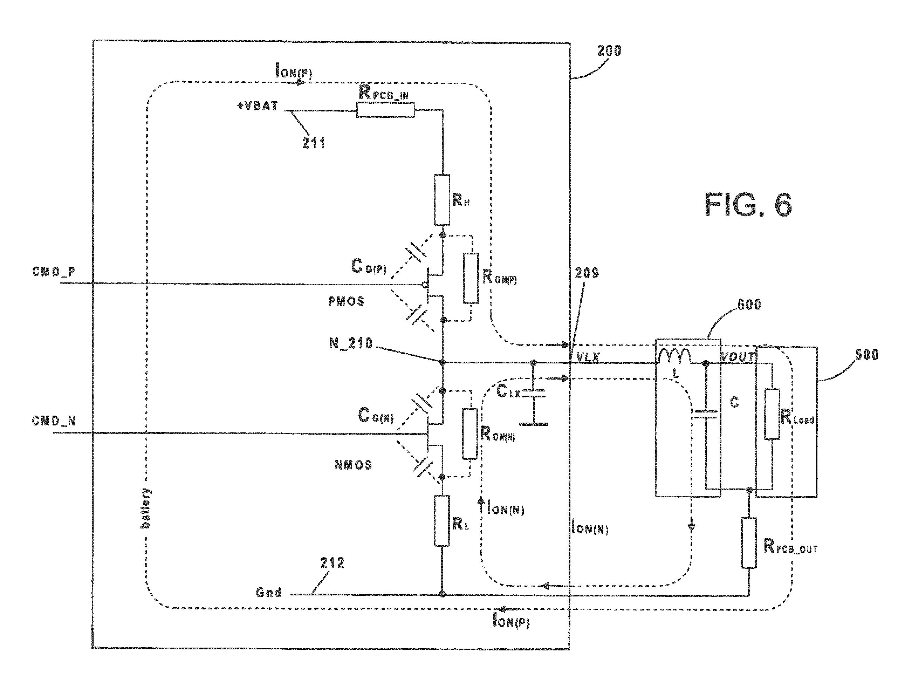

Like in all DC/DC converters the power losses are the sum of switching (dynamic) and ohmic or Joule (static) losses. The former stem from the necessity of driving the transistor parasitic gate capacitances commonly referred to as $C_{G(N)}$ and $C_{G(P)}$. The later stem from parasitic resistances including intrinsic NMOS and PMOS channel resistances commonly referred to as the $R_{ON(N)}$ and $R_{ON(P)}$ resistances, in addition to the resistance of all metallic connections as the inductor or PCB one. A Simplified scheme of a Switched Power Supply Circuit containing these parasitic elements is shown on **FIG.6.**

In this Figure, two current paths are represented. A first current path, named $I_{ON(P)}$ for the PMOS transistors, occurs during the PMOS transistors conduction phase. A second current path named $I_{ON(N)}$ for the NMOS transistors occurs during the NMOS transistors conduction phase. $R_{ON(N)}$ and $R_{ON(P)}$ are the ON-channel resistances of the PMOS and NMOS transistors, respectively. $R_H$ and $R_L$ are the Source and Drain metallic access resistances of the transistors; and resistances $R_{PCB,IN}$ and $R_{PCB.OUT}$ being the sum of all remaining input and output wiring resistances, which are encountered in the current path of $I_{ON(N)}$ and $I_{ON(P)}$ (*e.g.* PCB routing resistance, package access resistances, input filter). A capacitance $C_{LX}$ of the output of the Switched Power Supply Circuit is further shown on **FIG.6**, which is usually dominated by the sum of NMOS and PMOS drain overlap and junction capacitances. An inductance (not shown) may be coupled to the capacitor and resistor of the Load module 500.

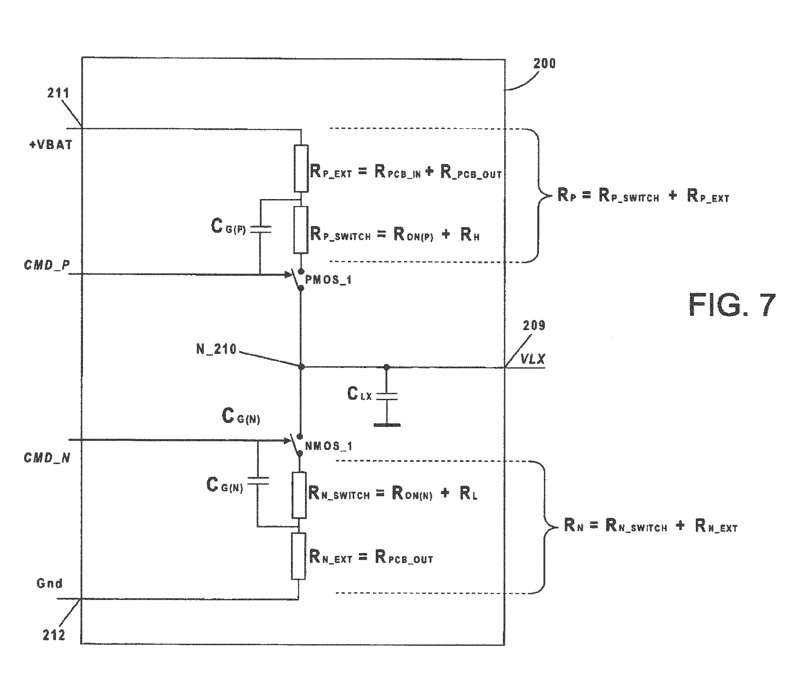

For a better understanding, the equivalent circuit on the **FIG.6** can be simplified into the circuit shown in **FIG.7.** In this schematic, $R_{N.P}$ are the total resistances related to the ohmic losses during the NMOS and PMOS conduction phases, and $R_{P.N\_SWITCH}$ are the resistance of switches inside the package (MOS $R_{ON}$ with metallic access resistance). Further, $R_{N.P\_EXT}$ are the sum of all external resistances. The losses in a SPS module 200 composed by power MOS transistors are characterized by:

$$P_{LOSSES} = R * I_{OUT}^2 + CV^2 f_{CLK} \tag{1}$$

with:

$$R = DR_P + (1 - D)R_N \tag{2}$$

where:

R is the average resistance of the system,
C is the sum of all parasitic capacitances (charge/discharged) with $f_{CLK}$ rate,
$f_{CLK}$ is the clock frequency of the *Duty_cycle* signal,
Iout is the DC output current,
D is the high state of the *Duty_cycle* signal, and
(1-D) is the low state of the *Duty_cycle* signal.

The proposed device and method allow determining the maximum peak efficiency of the SPS module 200, by derivating the output current named Iout in equation 2, so that:

$$I_{OUT(\max \eta)} : \frac{d\eta}{dI_{OUT}} = 0 \tag{3}$$

where:

$\eta$ is the efficiency of the Supply Power Stage defined as $\eta$ = Pout/Pin,
$I_{OUT}$ is the output current.

The output current corresponding to the peak efficiency operations of a given power switch (i.e. PMOS or NMOS) results from previous as:

$$I_{OUT(max\,\eta)} = V_{BAT} \sqrt{\frac{C \cdot f_{CLK}}{T_{ON} \cdot R}} \tag{4}$$

Where TON is the conduction time of the related switch (PMOS or NMOS). The formula presented above signifies that the peak efficiency occurs when switching and ohmic losses are equal, namely when:

$$\underbrace{R I^2_{OUT(max\,\eta)}}_{\text{ohmic losses}} = \underbrace{C V^2_{BAT} f_{CLK}}_{\text{switching losses}} \tag{5}$$

The real joule power dissipated during conduction cycles of NMOS switch resistance $R_{N\_SWITCH}$ can be then obtained as:

$$P_{N\_SWITCH} = (1 - D) R_{N\_SWITCH} I^2_{OUT} \tag{6}$$

Applying the recopied current $\alpha I_{out}$ to resistance $R_N/\alpha$ (integrated inside the PED) allow to reconstitute voltage drop related to total joule losses during the NMOS conduction cycle. This voltage is then:

$$V_{N\_ON\_AVG} = I_{OUT} R_N \tag{7}$$

And the joule losses due to the NMOS condition phase are therefore:

$$P_N = (1 - D) R_N I^2_{OUT} \tag{8}$$

Considering the short mathematical demonstration presented above, it will be appreciated that the ohmic losses and switching losses have to be identified and estimated during operation of the SPS circuit. In one embodiment of the invention, it is proposed that the PED module 300 be adapted to create replica of the ohmic losses and compare it with switching losses occurring during said operation.

The internal structure of a NMOS power transistor is different than the internal structure of the PMOS power transistor. Indeed, different doping solutions, internal structure and types of charge carriers are used during the conception of a NMOS or PMOS transistor. Hence, ohmic and switching losses are different in a PMOS transistor than in a NMOS transistor. To measure and create replica losses, a specific circuit for the peak-efficiency detection of the NMOS transistor and the PMOS transistor may be realised. In the following description, only the case of a NMOS transistor is described. Further, as shown on **FIG.1** and **FIG.2,** the input signal of the PED module 300 is provided by the output VLX, CMD_P and CMD_N of the SPS module 200.

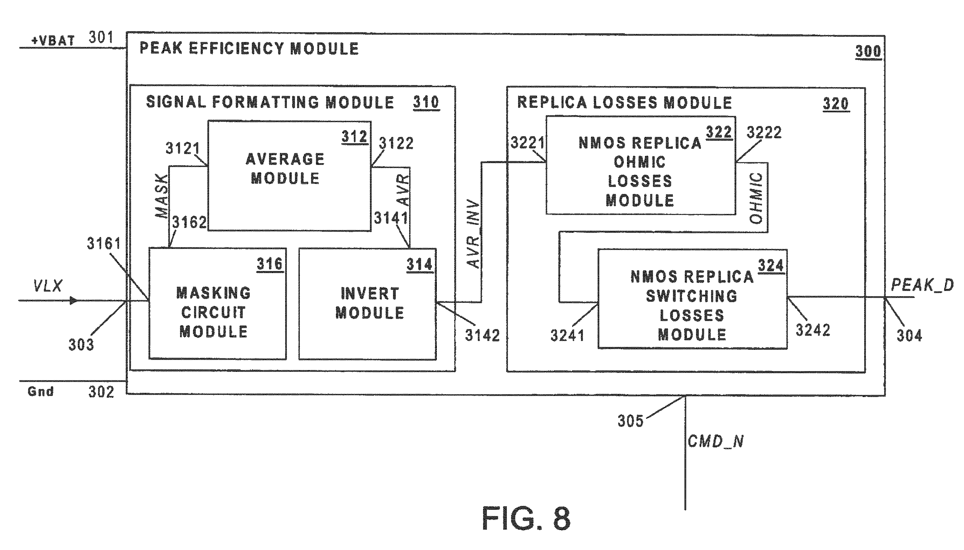

The PED module 300 (as shown in **FIG.8)** may be adapted to receive, on its inputs 301 and 302, the supply voltages +*VBAT* and *Gnd*, respectively, from the power supply source 100. An input 305 may be adapted to receive the output signal *CMD_P,* an input 306 may be adapted to receive the output signal *CMD_N* from the SPS module 200, while another input 303 may be adapted to receive the output signal *VLX* from the SPS module 200, and still another two inputs 304 and 307 may be adapted to receive respectively the signal *EN_P* and the signal *EN_N* from the Power Stage Size control module 400. Further, the PED module 300 may be adapted to provide on an output 304 an output signal named *PEAK_D* which is representative of the efficiency of the SPS module 200.

For a better understanding of the invention, in the following description only the case with a peak efficiency module 300 for a NMOS transistor is described.

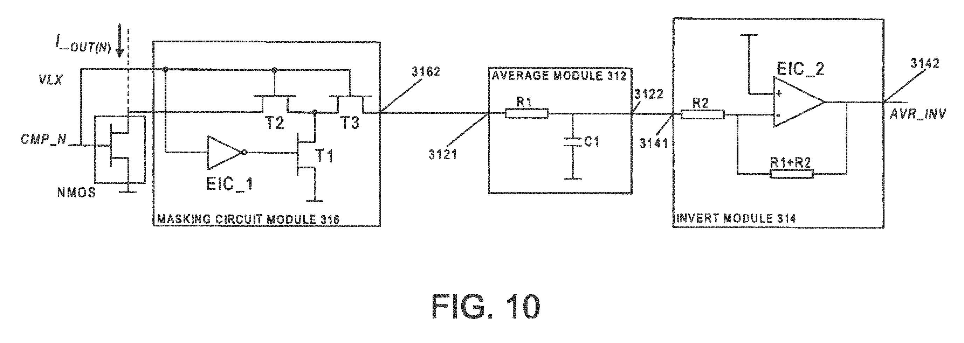

The internal structure Fig. 8 of the PED module 300 can be divided in two main modules, such as a signal formatting module 310 (Fig. 10), and a replica of ohmic losses module 320. These modules can comprise several internal functions provided by integrated electronic circuits such as resistors, capacitances, OAs, and transistors that they are described in more details below.

In order to discriminate in the *VLX* signal the duration of the conduction of the PMOS transistors and the duration of conduction of the NMOS transistors, the signal formatting module 310 comprises three modules, namely a first module named masking circuit module 316, a second module named Averaging module 312, and a third module named invert module 314.

The masking circuit module 316 has an input 3161 coupled to the input 303 of the PED module 300, and said input is adapted to receive the signal *V_LX* from the SPS module 200. The masking circuit module 316 is adapted to provide a filtered signal named *MASK* on an output 3162.

The average module 312 is adapted to receive on an input 3121 the signal *MASK from* the masking circuit module 316 and is adapted to provide an output signal named AVR on an output 3122 where, said output signal AVR is the average value of the signal *MASK*. The invert module 314 is adapted to receive on an input 3141 the signal *AVR* from the output of the average module 312 and to provide on an output 3142 an output signal named *AVR_INV,* that is to say the invert value of the input signal thereof.

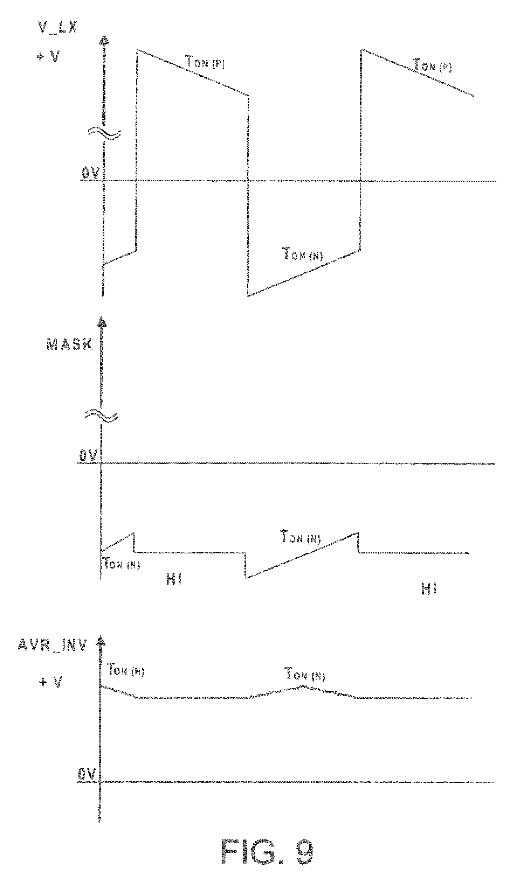

The graph on **FIG.9** shows the several output signals of the three modules of the signal formatting module 310. The masking circuit module 316 helps to remove the high voltage from the *VLX* signal so as to keep the NMOS signal only (signal across the NMOS ON resistance when this transistor is conducting). An example of electronic circuit performing this function is shown in **FIG.10.** This electronic circuit comprises for instance an electronic inverter circuit named EIC_1 coupled to a first MOS transistor T1, and two other transistors named respectively T2 and T3. This electronic circuit senses the voltage across the NMOS switches when it is ON (conducting), provides the output signal *MASK* during the NMOS transistor conduction period $T_{ON(N)}$. and sets the output 3162 to a high impedance in the remaining time.

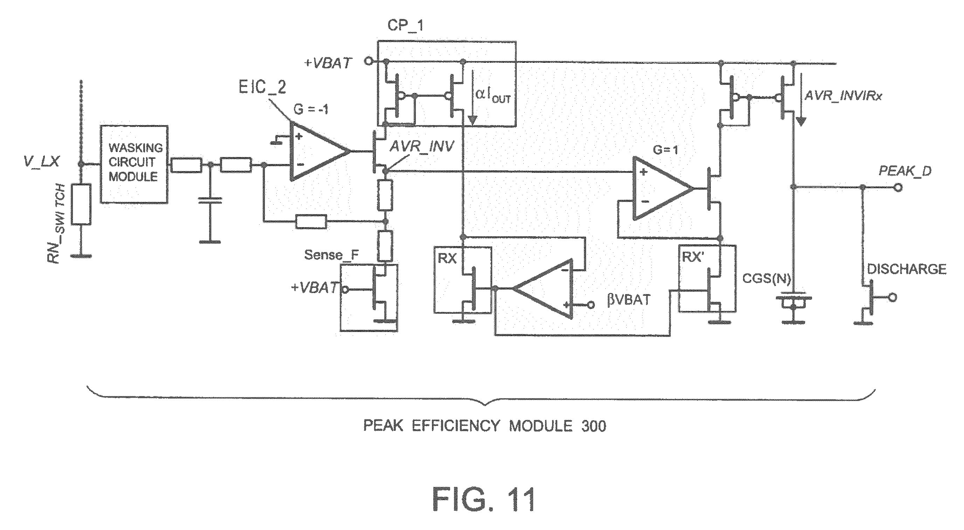

Estimating the losses in the NMOS transistor, is based on the averaging during one conduction cycle. Therefore, the second module named average module 312 provides on this output 3122 an average value of the input signal 3121 from the masking circuit module 316. On **FIG.11,** an example of electronic circuit performing this function is shown. The average function is made by a RC filter which provides an average voltage only during the transistor conduction (when transistor is 'ON'), and holds the average voltage on the filter capacitor afterwards.

For a simplest circuitry of the PED module 300, an invert value of the signal may be provided by the invert module 314. To that end, the invert module 314 may be adapted to invert the input signal AVR and to provide an output signal with an invert value of the AVR signal. This function can be obtained by an OPA (OPerational Amplifier) EIC_2 with an amplification gain of -1 **(FIG.10).**

All electronics circuits and circuitries presented above for the modules 312, 314, 316 are presented in the present description for exemplary purpose of only. Other types of circuits, electronic components could be used for realizing these different modules. Also, in other embodiments, digital circuits such as ASIC, FPGA or any other type of programmable electronic circuits could be used to design this module in part or in totality.

As explained above, one function of the PED module 300 is to create a replica of the ohmic and sand compare it to the switching losses during the conduction phase of the NMOS transistor of the SPS module 200.

In one embodiment, the NMOS replica ohmic losses module 322 **(FIG.9)** may comprise an electronic circuit adapted to create a replica of all ohmic losses in the NMOS transistor, namely parasitic resistance losses and connection resistances losses, for instance. The NMOS replica ohmic losses module 322 is adapted to provide a replica output current of the NMOS transistor of the SPS circuit current during the conduction phase thereof. As will be appreciated by the one skilled in the art, a sense-FET transistor could be used for creating a replica current **(FIG.11)**.

To obtain a replica current, the sense-FET transistor named Sense_F may be designed with a scaled coefficient named $\alpha$-scaled which allows to obtain scaled resistance (weighted by the $\alpha$-scaled coefficient) to the ohmic resistance of the NMOS transistor used in the SPS Circuit 210 for instance. This sense-FET provides a replica current with a smaller area and a smaller consumption of current.

As explained above several ohmic losses appear during the conduction of the NMOS transistor. In other embodiment an electronic circuit may allow to create a scaled auxiliary resistor named for instance Rx **(FIG.11).**

The two electronic circuits presented above allow to obtain the replica of the current though the Sense-FET independently of the duty cycle D of the output signal *VLX.*

To fully estimate and replicate all ohmic losses in a SPS module, it is possible to create a copy resistor RN/$\alpha$ arranged to provide the power dissipated in the power MOS transistor. In one embodiment, there is created a "sense" resistor RN/$\alpha$ with a gain alpha $\alpha$ **(FIG.11).** An important fact is that the current passing through the scaled sense-FET is the absolute-value replica of the output current, i.e. has no duty-cycle dependency, and the real power dissipated during the conduction cycles of NMOS transistor is equal to a resistance $R_{NMOS}$

$$P_{NMOS} = (1-D)R_{NMOS} \times I^2_{OUT} \qquad (6)$$

Applying the recopied current $\alpha I_{out}$ to resistance $R_N/\alpha$ allow to reconstitute voltage drop related to total joule losses during the NMOS conduction cycle. This voltage is then:

$$V_{N\_ON\_AVG} = I_{OUT} R_N \qquad (7)$$

The joule losses due to the NMOS condition phase are therefore:

$$P_N = (1-D) R_N I_{OUT}^2 \qquad (8)$$

The method allowing to detect the peak efficiency operation presented here relies on a circuit, that allows to transfer the amount of energy dissipated on the parasitic resistance $R_N$ to an auxiliary capacitor $C'_{G(N)} = C_{G(N)}$. In doing so, when both energies are equilibrated (energy required to charge capacitor $C_{G(N)}$ and joule heat energy dissipated on $R_N$), capacitor $C'_{G(N)}$ will be charged to $V_{BAT}$ at the peak efficiency operating point. Said otherwise, in a case of peak efficiency operation, auxiliary capacitor store identical amount of energy as the energy, being dissipated on the resistance $R_N$ during one conduction cycle.

The methodology introduced here is demonstrated on the NMOS part of the power switch. However, as already mentioned, two independent circuit allowing efficiency optimisation of NMOS and PMOS power switches are to be implemented.

The principle of the method can appear from the definition of the work required to establish a defined voltage across the capacitor plates. This work can be developed as:

$$W = \int_0^Q V dq = \int_0^Q \frac{q}{C} dq = \frac{1}{2} C V^2 = \frac{1}{2} V Q \qquad (9)$$

From physical definition, electrical charge Q is defined as the current by time product. On this account, the last term in Eq.(9) can be written into following (unusual) form:

$$W = \frac{1}{2} V_{BAT} Q = \frac{1}{2} V_{BAT} I_B T_{CLK} \qquad (10)$$

where $I_B$ is constant bias current which is to be applied to the auxiliary capacitor $C'_{G(N)}$. However, this equation is only valid when $I_B T_{CLK} = C \cdot V_{BAT}$. For one particular value of $I_B$, we can obtain exact voltage $V_{BAT}$ across the capacitor at $t = T_{CLK}$.

In the process of capacitor charging, half to the energy is dissipated on the resistive switch and half is stored in the capacitor. On this account, term ½ in Eq.(9) disappear. Now, we can be combined with Eq. (8) resulting in the energy balance:

$$(1-D) R_N I_{OUT}^2 = I_B T_{CLK} V_{BAT} f_{sw} \qquad (11)$$

Eq. 11 can be simplified by decreasing the time of integration from $T_{CLK}$ to $(1-D)T_{CLK}$. Then $T_{ON(N)} = T_{CLK}(1-D)$ and Eq. 11 results in:

$$R_N I_{OUT}^2 = I_B T_{ON(N)} V_{BAT} f_{sw} \qquad (12)$$

By rearranging this Eq.(12), we can obtain the bias current value:

$$I_b = \underbrace{I_{OUT} R_N}_{V_{N\_on\_avg}} \cdot \underbrace{\frac{\alpha I_{OUT}}{\beta V_{BAT}}}_{1/R_X} \qquad (13)$$

If such current is applied to the capacitor $C'_{G(N)} = \frac{\alpha}{\beta} C_{G(N)}$, the voltage $V_{C(GN)}$ reaching $V_{BAT}$ at the end of integration interval signifies, that the power switch operates at the peak efficiency.

In fact, Eq. (13) allows to realise linear circuit allowing to measure the average energy dissipated on the $R_N$ resistance during one clock period, and to store identical amount of energy in the auxiliary capacitor $C'_{G(N)}$. Otherwise, if $V_{CG(N)}$ voltage is lower than $V_{BAT}$ at the end of the integration time which corresponds to the $T_{ON}$ of the NMOS transistor, then the switching dynamic losses are dominating (power-MOS size is to be decreased), and on the contrary, when $V_{CG(N)}$ exceed the battery voltage at $t = T_{ON}$, the ohmic losses are dominating and the power MOS size is to be increased, and

For that, the NMOS replica switching losses module 324 is adapted to receive on an input 3241 the signal *OHMIC* from the NMOS replica ohmic losses module 322 and is adapted to provide on an output 3242 an output signal named *PEAK_D* replica of the total losses (ohmic losses and switching losses) of the SPS module 200. This module may use an auxiliary capacitor C'$_{G(N)}$ where:

$$C'_{G(N)} = C_{G(N)} \qquad (14)$$

The value of the auxiliary capacitor C'$_{G(N)}$ is determined during the conception of the NMOS replica switching losses module 324 and is in accordance with the intrinsic characteristics of the capacitor of the SPS circuit. An example of implementation is presented on **FIG 11.**

In other embodiment, a ohmic replica losses module 310 is used. This ohmic replica losses module 310 is designed to create total ohmic replica losses for all SPS circuits configurations. A control signal from the Power size stage control module 400 in other embodiment of the invention could be used to select a part of all ohmic replica losses of the ohmic replica losses module 310 in accordance with the number of activated SPS circuits.

As explained above, the maximum peak efficiency appears when the ohmic losses are identical to the switches losses. The detection of operation at the peak efficiency relies on a circuit that allows to transfer the amount of power dissipated on the parasitic resistances to an auxiliary capacitor C'$_{G(N)}$. When both power are balanced (power required to charge capacitor $C_{G(N)}$ and Joule power dissipated on $R_N$ during one conduction cycle), then the capacitor $C'_{G(N)}$ is charged to *VBAT* at the peak efficiency operating point. Stated otherwise, in a case of peak efficiency operation, auxiliary capacitors store identical amount of power as the power being dissipated on the resistance $R_N$ during one conduction cycle.

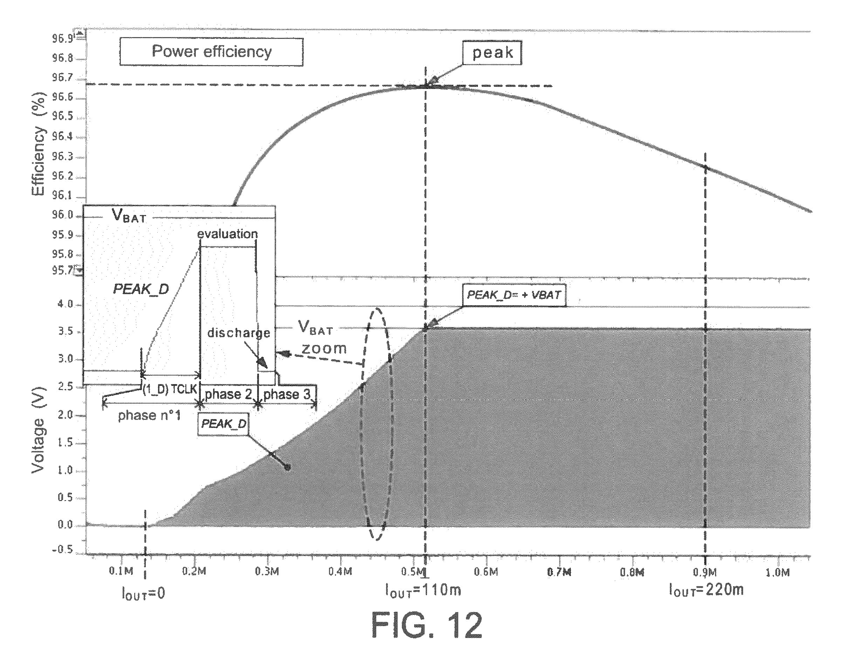

The graph on **FIG. 12** shows simulation results of a Peak Efficiency Detection device 1. In order to describe operation of the device 1, simulations were performed with real NMOS power transistor mathematical models, with a linear sweep of the output current (load current) from 0 to 300mA. In these simulations, the integration time is $T_{ON}$. The maximum peak efficiency was obtained when the voltage of the capacitors C'$_{GS}$ is equal to +*VBAT.*

In **FIG.12** a zoom allows to highlight the different phases which enable to obtain the maximum peak efficiency. Three phases of operation are identified, namely:

Phase No.1:   integration time, when current $I_B$ is applied to $C'_{G(N)}$,

Phase No.2:   evaluation phase, when the capacitor holds the integrated voltage value and value of the integrated voltage is evaluated, and

Phase No.3:   capacitor reset phase.

The phase No.1 allows to charge C'$_{GS}$ by a current $I_B$ during the time of the conduction of the Power NMOS transistor in SPS circuit. The charging of this capacitance is performed by a constant current and the duration of this charging is equal to the conduction time of related transistor.

The phase No.2 allows to evaluate the voltage across the capacitor C'$_{GS}$ in the Power stage size control module 400 by comparator COMP_3. Further, as explained above, when the value of this signal is below the value +*VBAT* that signifies that the switching losses are dominating the ohmic losses and when the voltage value is above or in our case equal to +*VBAT* that signifies the ohmic losses are dominant compared to the switching losses. The regulations of these parameters are made by activating or disabling segments of the SPS circuit. We notice that $V_{CAP}$ reaches +*VBAT* at the point of maximum efficiency.

The phase No.3 allows discharging the power stored in the capacitor $C'_{GS}$ quickly before another phase of efficiency regulation. This discharge of the capacitor $C'_{GS}$ could be performed by a transistor coupled in parallel to the said capacitor, and the discharge time is controlled by the internal resistor of the transistor.

In one embodiment of the invention, the power stage modulation strategy could be exploited in the following way:

- real time power stage size tuning.

This allow regulate he size of the power stage with a defined power regulation strategy for obtaining an optimal peak efficiency of the SPS module.

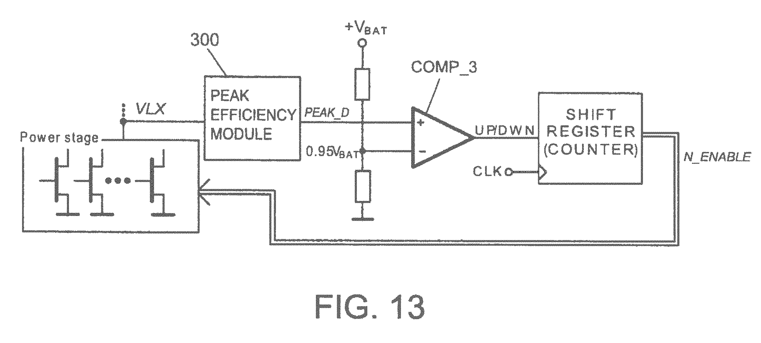

In there embodiment of the invention, a real time tuning of the size of the power supply stage is performed, as shown on **FIG. 13** an example of electronic circuit. The Power stage size control module 400 comprises a comparator electronic circuit named COMP_3 and a shift register. This shift register is adapted to receive on an input the signal PEAK_D from the PED module 300 and to receive on a second input a clock signal CLK. It allows to activate or disable the SPS circuits 210, 220,..., 2N0 incrementally.

To summarized the SPS module is configured to dynamically activate or deactivate at least one of the SPS circuits 210 operating to generate the output supply signal *V_OUT* on the internal central node N_2, when the signal *PEAK_D* representative of the efficiency of the SPS module is lower than threshold value (close to VBAT) meaning that the switching losses of the SPS module 200 are preponderant over the ohmic losses, or when said signal *PEAK_D* representative of the efficiency of the SPS module is higher than a second threshold value meaning that the ohmic losses of the SPS module 200 are preponderant over the switching losses, respectively.

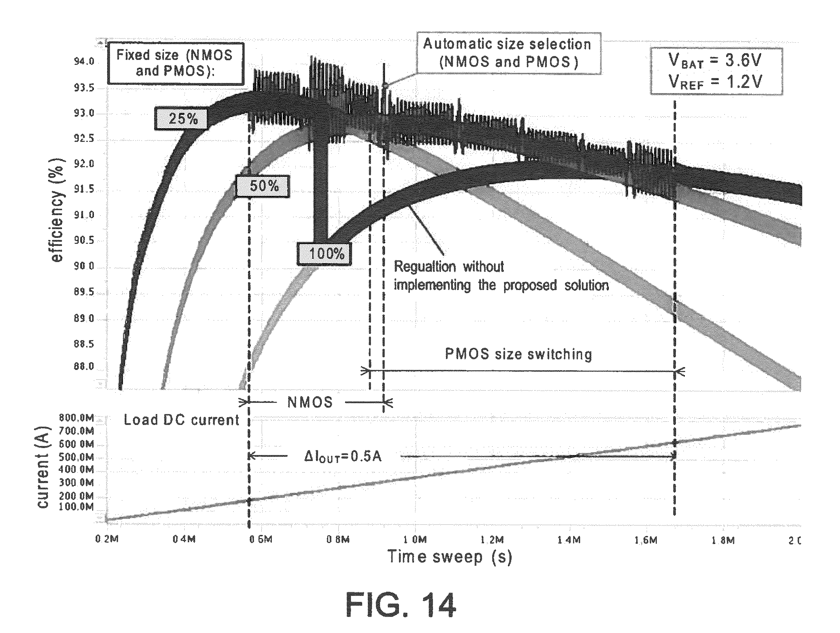

This is explained with reference to **FIG.14.** There are shown therein three curves in dotted lines corresponding to the power efficiency of the SPS module having three size activated: 25%, 50% and 100%, respectively, of the SPS module.

As shown in **FIG.14,** the regulation of the size of the SPS module 200 without implementing the proposed embodiments causes big jumps of the efficiency of the SPS module 200, represented by the continuous line, during the regulation phase of the SPS module. These jumps correspond to the activation of a second SPS circuit which changes the power efficiency from 25% to 100%. Another typical case without implementing the proposed embodiments is that the power-efficiency follows only 100% power-stage size.

As shown in **FIG.14,** the regulation of the size of the SPS module 200 with the defined power regulation strategy and defined internal structure as explained above allows to avoid big jumps of the efficiency signal PEAK_D during the regulation phase of the SPS module 200 with the power stage size control module 400 as explained above. Thus, the curve in continuous line in FIG.14 exhibits faster, but smaller changes of the power efficiency obtained when the proposed regulation scheme is implemented. Moreover, the proposed strategy optimise the power efficiency with respect to all main parameters having direct impact to the power efficiency value, as the input and output voltage $V_{BAT}/V_{OUT}$, output current $I_{OUT}$, switching frequency $F_{CLK}$, Temperature, and process variations.

While the invention has been illustrated and described in details in the drawings and foregoing description, such illustration and description have to be considered as illustrative or exemplary and not restrictive; the invention is not limited to the disclosed embodiments. Variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single or a plurality of programmable circuit or other unit may fulfil the functions of several items recited in the claims. The mere fact that certain measures are recited in mutually different dependent claims does not indicate that a combination of these measures cannot be used to advantage.

**Claims**

1. A device (1) for Peak Efficiency Detection, PED, for a Switched Mode Power Supply, SMPS, comprising:

   - a Switched Power Supply, SPS, module (200) adapted to provide an output supply signal *(VLX)* of the device, comprising at least:

     ▪ an internal central node (N_2); and,

- a plurality of SPS circuits (210) adapted to generate in combination the output supply signal (*VLX*) on the internal central node (N_2),
- a Dead time module (800) adapted to generate two control signals (*CMD_P*) and (*CMD_N*) with a small non-overlap time,

- a central node (N_1) external to the SPS module and adapted to deliver the output supply signal to a load module (500),
- a PED module (300) adapted to receive the output supply signal (*VLX*) from the central node (N_1), the control signals (*CMD_P*) and *(CMD_N)* from the SPS module (200), signals (*EN_P, EN_N*) from a Power stage size control module (400) and to provide a signal (*PEAK_D*) representative of an efficiency of the SPS module (200), comprising at least:

- a Signal Formatting module (310) adapted to provide a formatted signal from the output supply signal,
- a Replica Losses module (320) adapted to provide a signal representative of ohmic and switching losses of the SPS module (200) based on the formatted signal,

- the Power stage size control module (400) adapted to provide at least two control signals (*EN_P, EN_N*) for controlling the SPS module (200),

wherein, the SPS module is configured to activate or deactivate at least one of the SPS circuits (210) operating to generate the output supply signal *(VLX)* on the internal central node (N_2), when the signal (*PEAK_D*) generated by the PED module (300) and representative of the efficiency of the SPS module is lower than a threshold value meaning that the dynamic losses of the SPS module (200) are preponderant over the ohmic losses, or when said signal (*PEAK_D*) representative of the efficiency of the SPS module is higher than the threshold value meaning that the ohmic losses of the SPS module (200) are preponderant over the dynamic losses, respectively.

2. The device of claim 1, wherein the SPS circuits (210) comprise at least one power switch.

3. The device of claim 2, wherein the power switch comprises a power Metal Oxyde Semiconductor, MOS, transistor.

4. The device of claims 1 to 3, further comprising serial communication means (12, 14) adapted to allow communication between the PED module (300), the power stage size control module (400), and the SPS module (200).

5. The device of claims 1 to 4, wherein the ohmic losses module (310) comprises at least a copy transistor (Sense_F) configured to replicate a current through the SPS circuits with a scale ratio and to derive there from a current representative of the ohmic losses of the activated SPS circuits (210,220,...2N0).

6. The device of claims 1 to 5, wherein the switching losses module (300) comprises at least an auxiliary capacitor (CLX) configured to be charged by the current representative of the ohmic losses of the SPS circuits and to derive there from a voltage signal representative of the switching losses of the activated SPS circuits (210,220,...2N0).

7. A method of Peak Efficiency Detection, PED, for a Switched Mode Power Supply, SMPS, comprising:

- a Switched Power Supply, SPS, module (200) providing an output supply signal (*VLX*) of the device with

- at least some of a plurality of SPS Circuit (210) generating in combination said output supply signal (*VLX*) on an internal central node (N_2) internal to the SPS module,
- a Dead time module (800) providing two control signals (*CMD_P* and *CMD_N*),

- a central node (N_1) external to the SPS module delivering the output signal *(VLX)* to the load module (500),
- a PED module (300) receiving the output supply signal from the central node (N_1), the control signals (*CMD_P, CMD_N*) from the SPS module (200), the signals (*EN_N, EN_P*) from a power stage size control module (400), and providing a signal (*PEAK_D*) representative of an efficiency of the SPS module (200), with:

- a Signal Formatting module (310) providing a formatted signal from the output supply signal,
- a Replica Losses module (320) providing a signal representative of ohmic and switching losses of the SPS module (200) based on the formatted signal,

- a Power stage size control module (400) providing at least two control signals (*EN_P, EN_N*) for controlling the SPS module (200),

wherein the method further comprises:

- activating or deactivating at least one of the SPS circuits (210) operating to generate the output supply signal on the internal central node (N_2), when the signal (*PEAK_D*) generated by the PED module and representative of the efficiency of the SPS module is lower than a threshold value meaning that the dynamic losses of the SPS module (200) are preponderant over the ohmic losses, or when said signal (*PEAK_D*) representative of the efficiency of the SPS module is higher than the threshold value meaning that the ohmic losses of the SPS module (200) are preponderant over the dynamic losses, respectively.

8. The method of Peak Efficiency Detection of claim 7, wherein the duration of conduction of the SPS circuits is controlled by (*CMD_P, CMD_N*) control signals.

9. The method of Peak Efficiency Detection of claims 7 and 8, wherein each transistor of each SPS circuit is activated by *(EN_P, EN_N)* signals.

FIG. 1

PEAK EFFICIENCY DETECTION 1

K1
+VBAT

Duty_Cycle

100

R_BAT

EXTERNAL
CONTROLLER

K2
Gnd

202

205

204

206 EN_P

406

401

402

208

EN_N

408

404

SWITCHED
POWER
SUPPLY
MODULE

200

207
CMD_P
203
CMD_N

209
VLX
N_1

POWER
STAGE
SIZE
CONTROL
MODULE

400

301
305

306

303
304

307
302

PEAK
EFFICIENCY
MODULE

300

PEAK_D

308

K3
601

L

C

FILTER
MODULE 600

602

V_OUT

K4

LOAD
MODULE

500

EP 2 863 526 A1

15

FIG. 2

SWITCHED POWER SUPPLY MODULE

200

Duty_Cycle 205

+VBAT 202

Gnd 204

CMD_P 207

CMD_N 203

VLX 209

DEAD TIME MODULE 800

802 804

CMP_P

CMP_N 806

SWITCHED POWER SUPPLY CIRCUIT N 2N0

SWITCHED POWER SUPPLY CIRCUIT 2 220

SWITCHED POWER SUPPLY CIRCUIT 1 210

VLX_N 2N5

N_2 225

VLX_1 215

2N7 2N4 2N3 2N6 227 226 224 223 217 217

EN_N 208 14

EN_P 206 12

FIG. 3

FIG. 4

Switched Power Supply Circuit 1

FIG. 5

FIG. 6

EP 2 863 526 A1

$$R_{P\_EXT} = R_{PCB\_IN} + R_{PCB\_OUT}$$

$$R_{P\_SWITCH} = R_{ON(P)} + R_H$$

$$R_P = R_{P\_SWITCH} + R_{P\_EXT}$$

$$R_{N\_SWITCH} = R_{ON(N)} + R_L$$

$$R_{N\_EXT} = R_{PCB\_OUT}$$

$$R_N = R_{N\_SWITCH} + R_{N\_EXT}$$

FIG. 7

FIG. 8

EP 2 863 526 A1

FIG. 9

FIG. 10

FIG. 11

FIG. 12

FIG. 13

FIG. 14

EP 2 863 526 A1

| | Europäisches Patentamt European Patent Office Office européen des brevets | **EUROPEAN SEARCH REPORT** | Application Number EP 13 30 6449 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/176015 A1 (SATO TETSUO [US] ET AL) 11 July 2013 (2013-07-11) * paragraph [0018] - paragraph [0053] * ----- | 1-9 | INV. H02M1/088 H02M3/158 |
| A | DE 10 2011 014165 A1 (FEAAM GMBH [DE]) 20 September 2012 (2012-09-20) * paragraph [0003] - paragraph [0019] * * paragraph [0041] - paragraph [0055] * * figures 3-6 * ----- | 1-9 | ADD. H02M1/00 |
| A | US 2008/111529 A1 (SHAH SHREYA [US] ET AL) 15 May 2008 (2008-05-15) * the whole document * ----- | 1-9 | |
| A | WO 2008/135637 A1 (NOKIA CORP [FI]; MURTOJAERVI SIMO [FI]) 13 November 2008 (2008-11-13) * the whole document * ----- | 1-9 | |
| | | | TECHNICAL FIELDS SEARCHED (IPC) H02M H03K |

| | |
|---|---|
| The present search report has been drawn up for all claims | |

| Place of search | Date of completion of the search | Examiner |
|---|---|---|
| The Hague | 28 March 2014 | Lochhead, Steven |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                                   
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 30 6449

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2014

| Patent document cited in search report | Publication date | Patent family member(s) | Publication date |
|---|---|---|---|
| US 2013176015 A1 | 11-07-2013 | US 2013176015 A1<br>WO 2013106396 A1 | 11-07-2013<br>18-07-2013 |
| DE 102011014165 A1 | 20-09-2012 | DE 102011014165 A1<br>DE 112012001260 A5<br>WO 2012122978 A2 | 20-09-2012<br>27-02-2014<br>20-09-2012 |
| US 2008111529 A1 | 15-05-2008 | NONE | |
| WO 2008135637 A1 | 13-11-2008 | CA 2684917 A1<br>CN 101689806 A<br>EP 2145382 A1<br>US 2008278136 A1<br>WO 2008135637 A1 | 13-11-2008<br>31-03-2010<br>20-01-2010<br>13-11-2008<br>13-11-2008 |

EPO FORM P0459

For more details about this annex : see Official Journal of the European Patent Office, No. 12/82